(19) Europäisches Patentamt
European Patent Office
Office européen des brevets

(11) **EP 3 008 982 B1**

(12) **EUROPÄISCHE PATENTSCHRIFT**

(45) Veröffentlichungstag und Bekanntmachung des Hinweises auf die Patenterteilung:
**24.10.2018 Patentblatt 2018/43**

(21) Anmeldenummer: **14731932.1**

(22) Anmeldetag: **11.06.2014**

(51) Int Cl.:
**H05K 7/14** *(2006.01)*

(86) Internationale Anmeldenummer:
**PCT/EP2014/062115**

(87) Internationale Veröffentlichungsnummer:
**WO 2014/198763 (18.12.2014 Gazette 2014/51)**

(54) **KODIERUNGSSYSTEM UND E/A-MODUL EINES AUTOMATISIERUNGSGERÄTES MIT EINEM SOLCHEN KODIERUNGSSYSTEM**

CODING SYSTEM AND I/O MODULE OF AN AUTOMATION DEVICE HAVING SUCH A CODING SYSTEM

SYSTÈME DE CODAGE ET MODULE E/S D'UN APPAREIL D'AUTOMATISATION DOTÉ D'UN TEL SYSTÈME DE CODAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.06.2013 DE 102013009682**

(43) Veröffentlichungstag der Anmeldung:
**20.04.2016 Patentblatt 2016/16**

(73) Patentinhaber: **Phoenix Contact GmbH & Co. KG 32825 Blomberg (DE)**

(72) Erfinder: **WILLE, Peter 33102 Paderborn (DE)**

(74) Vertreter: **Blumbach · Zinngrebe Patent- und Rechtsanwälte PartG mbB Elisabethenstrasse 11 64283 Darmstadt (DE)**

(56) Entgegenhaltungen:
**EP-A2- 2 568 788**

- **Anonymous: "SGI TPL (IRIX 6.5: End-User/HDIO_OG - Appendix B. Setting Up the HD I/O Board for Your Video Hardware)", , 14. Dezember 2000 (2000-12-14), XP055158783, Gefunden im Internet: URL:http://techpubs.sgi.com/library/tpl/cgi-bin/getdoc.cgi?coll=0650&db=bks&srch=&fname=/SGI_EndUser/HDIO_OG/sgi_html/apb.html [gefunden am 2014-12-15]**
- **"Programmable Controller IC600WDXXX GEK-83517F I/O Cables", , 1. April 2004 (2004-04-01), XP055158677, Gefunden im Internet: URL:http://support.ge-ip.com/support/resources/sites/GE_FANUC_SUPPORT/content/live/DOCUMENT/0/DO762/en_US/GEK83517F.pdf [gefunden am 2014-12-15]**
- **Anonymous: "Accessories", , 29. Mai 2013 (2013-05-29), XP55158743, Gefunden im Internet: URL:http://www.generalstandards.com/accessories.php [gefunden am 2014-12-15]**
- **Lumberg Automation: "Optimierung der Feldverdrahtung durch Einsatz einer modularen IP 67-Feldbuslösung", , 9 November 2009 (2009-11-09), pages 1-64, XP055368678, Retrieved from the Internet: URL:http://belden.picturepark.com/Website/Download.aspx?DownloadToken=2abc1cf3-1f02-450d-95f9-721132d8c1ce&Purpose=AssetManager&mime-type=application/pdf [retrieved on 2017-05-02]**

**Beschreibung**

Die Erfindung betrifft ein Kodierungssystem bestehend aus zumindest einer Anordnung von wenigstens zwei Einzeladern, wobei jeweils ein Ende einer jeden Einzelader an einen gemeinsamen Adapter angeschlossen ist, welcher mit einem E/A-Modul eines Automatisierungsgerätes zur Ankopplung eines externen Gerätes an eine Steuerung eines Automatisierungssystems zu verbinden ist sowie ein E/A-Modul eines Automatisierungsgerätes mit einem solchen Kodierungssystem.

Kodierungssysteme zur gegenseitigen Zuordnung von verschiedenen Komponenten, einschließlich optischer oder farblicher Kodierungssysteme, sind in mehreren Industrieanwendungen weitverbreitet.

Auch gibt es mehrere Arten von Kodiersystemen, um Nummerierungen oder beabsichtigte Funktionen von Leitungsadern eines Kabels mit Farben zu kennzeichnen. So sind z.B. Kodierungssysteme bekannt, um eine korrekte Verkabelung zu vereinfachen.

Entsprechend sollte beispielsweise bei dreiadrigen Kabeln, bei welchen z.B. eine der Adern mit Rot, eine der Adern mit Schwarz und eine der Adern mit grün/gelb gekennzeichnet ist, die rote Ader stets mit '+', die schwarze Ader stets mit '-' und die grün/gelbe Ader stets mit Masse verbunden werden.

Eine weitere Farbkodierung zur Adernkennzeichnung von Fernmeldekabel ist ferner z.B. mit der zwar zurückgezogenen, jedoch weiterhin noch oft verwendeten DIN 47100 gegeben.

Auch ist eine 25-Paar-Farbkennzeichnung bekannt, um individuelle Leiter bzw. Adern bei der elektrischen Telekommunikationsverkabelung zu kennzeichnen. Diese Kennzeichnung wird auch als "twisted-pair-cabling" bezeichnet und findet in der Regel bei RJ21 Kabeln Anwendung. Die Farben werden zur Kennzeichnung auf die Adernisolierungen aufgebracht. Hierbei wird für jedes verdrillte Adernpaar eine erste Farbe aus einer ersten Gruppe von fünf Farben und eine zweite Farbe aus einer zweiten Gruppe von fünf Farben gewählt, um somit insgesamt 25 Kombinationen von jeweils zwei Farben auszubilden.

Auch ist die farblich unterschiedliche Kennzeichnung von Kabeln, die mehrere Adern bündeln, bekannt, z.B. blaue und grüne Netzwerkkabel. Auch hierdurch soll eine Möglichkeit für den Anwender geschaffen werden, schnell zu erkennen, welche Komponenten mit welchen Kabeln zu verbinden oder verbunden sind.

Ferner ist z.B. aus der DE 40 16 445 A1 bekannt, sowohl in Kabeln gebündelte Adern als auch die Kabel selbst mit unterschiedlichen Farben zu kennzeichnen, um hierdurch die Kabel von einander unterscheiden zu können und auch die Adern innerhalb eines Kabels leicht zu identifizieren.

So kann demnach zusätzlich zum vereinfachten Zuordnen von einzelnen anzuschließenden Adern in einer Schaltung zusätzlich ein erstes farblich gekennzeichnetes Kabel einer ersten Schaltung und zweites farblich gekennzeichnetes Kabel einer zweiten Schaltung vereinfacht zugeordnet werden.

Aus der DE 43 95 807 T1 ist überdies bekannt, mehrere solcher Kabel innerhalb eines Kabelbaums zu bündeln und diesen wiederum mit einer Etikettierung zu versehen und/oder einzeln abgeschnittene Längen des Kabelbaums mit geeigneten Steckern für jedes Kabel und die darin enthaltenen Adern bzw. Leitern zu versehen.

Es ist auch bekannt, im Rahmen einer Verkabelung von Automatisierungssystemen, nachfolgend auch als Systemverkabelung bezeichnet, die Leitungsadern zur Übertragung von Eingabe-/Ausgabe-Signalen (E/A-Signale) zwischen einem Eingabe-/Ausgabe-Modul (E/A-Modul) eines Automatisierungsgerätes zur Ankopplung eines externes Geräts an eine Steuerung und diesem externen Gerät über einen gemeinsamen, an das E/A-Modul zu steckenden Stecker zu bündeln und dann die Leitungsadern von dem an das E/A-Modul gesteckten Stecker entweder in einem einzigen Kabel oder als Einzeladernbündel zu dem externen Gerät zu führen. Das E/A-Modul kann hierbei auch selbst Signalsteuerungs- und/oder Signalverarbeitungsfunktionen übernehmen. Diese Signalsteuerungs- und/oder Signalverarbeitungsfunktionen können hierzu z.B. auch auf einer vom E/A-Modul aufgenommenen, steckbaren Eingabe-/Ausgabe-Karte (E/A-Karte) beinhaltet sein, auf welcher diese Funktionen in Hardware (z.B. fest verdrahtet) und/oder in Software (z.B. mittels einer Speicher programmierten Steuerung "SPS") hinterlegt sind. Die E/A-Signale können hierbei je nach spezieller Ausführung Analogsignale und/oder Digitalsignale umfassen.

Das Dokument Lumberg Automation: "Optimierung der Feldverdrahtung durch Einsatz einer modularen IP 67-Feldbuslösung",, 9. November 2009 (2009-11-09), Seiten 1-64, XP055368678, zeigt ein Kodierungssystem zur Zuordnung von Leitungsadern zur Übertragung von E/A-Signalen zwischen einem E/A-Modul eines Automatisierungsgerätes und einem externen Gerät, wobei das Kodierungssystem eine Anordnung von mehreren Einzeladern besitzt, und wobei jeweils ein Ende einer jeden Einzelader dieser Anordnung an einen gemeinsamen Adapter angeschlossen ist, welcher mit dem E/A-Modul des Automatisierungsgerätes zur Ankopplung eines externen Gerätes an eine Steuerung eines Automatisierungssystems zu verbinden ist, wobei über den gemeinsamen, mit dem E/A-Modul zu verbindenden Adapter die Anordnung der Einzeladern festgelegt ist.

Externe Geräte, nachfolgend auch als Peripheriemodule bezeichnet, können hierbei insbesondere Module mit streckbaren Relais und andere Module, aber auch Feldgeräte als solche, wie Aktoren und Sensoren, sein. Als ein Beispiel für ein Modul mit streckbaren Relais kann das von der Anmelderin unter der Bezeichnung "V8 Adapter" vertriebene Modul genannt werden.

Der Anschluss an die externen Geräte erfolgt dann entweder über Klemmen z.B. mit Federkraft- oder Schraubschluss- oder mit Messertrennklemmen, oder über Steckersysteme wie z.B. das als D-SUB bezeichnete Steckersystem für Datenverbindungen und andere herstellspezifische Steckersysteme.

Ein Problem besteht nun z.B. darin, dass bei Verkabelungslösungen häufig die Adernzuordnung erheblich erschwert ist, je mehr Leitungsadern zwischen einem Eingabe-/Ausgabe-Modul (E/A-Modul) eines Automatisierungsgerätes und einem externen Gerät zur Signalübertragung erforderlich sind, welches letztendlich auch zu Verschaltungsfehlern und somit zu einem Fehlverhalten des Automatisierungssystems führen kann.

Sind z.B. zwischen einem Eingabe-/Ausgabe-Modul (E/A-Modul) eines Automatisierungsgerätes und einem externen Gerät 32 oder noch mehr Leitungsadern anzuschließen, sind allein bei 32 Leitungsadern, deren jeweils eines Leitungsadern-Ende an das E/A-Modul angeschlossen ist, 528 Anschlussmöglichkeiten gegeben, um auf Seiten des externen Gerätes die dortigen Leitungsadern-Enden in einer bestimmten Anordnung zu identifizieren und an diesem gemäß einer vorbestimmten Adernzuordnung entsprechend anzuschließen. Denn zunächst muss eine Leitungsader aus 32 Leitungsadern identifiziert werden, daraufhin eine weitere Leitungsader aus den verbleibenden 31 Leitungsadern, und so weiter.

Bevorzugt werden daher bereits heute z.B. 8 bis 10 Einzeladern zusammengefasst und mit einem Kabelmantel versehen. Bei insgesamt 40 Einzeladern, deren jeweils eines Leitungsadern-Ende an das E/A-Modul angeschlossen ist, können diese vom E/A-Modul ausgehend so z.B. innerhalb 4 Kabel mit jeweils zumindest 1 Stecker zum Verbinden mit einem externen Gerät gebündelt werden, wobei in diesem Fall jeder Stecker zum Verbinden mit dem externen Gerät z.B. 10 Kontakte aufweist. Je ein mit dem externen Gerät zu verbindender Stecker kann dann ferner z.B. im Fall von digitalen Signalen 1 Byte repräsentieren, wobei im Falle von jeweils 10 gebündelten Einzeladern auch noch zusätzliche Signale mit übertragen werden können, z.B. zwei weitere 1-Bit-Signale oder die Spannungsversorgung des Bytes mit einem Plus- und Minussignalleiter.

Anstelle der mit dem externen Gerät zu verbindenden Stecker können die Einzeladern auch zumindest an diesem Kabelende aus diesem herausschauen, um mit dem externen Gerät verbunden zu werden, wobei die Einzeladern dann z.B. Bit für Bit an das externe Gerät angeschlossen werden müssen.

Zur Verringerung von Verschaltungsfehlern sind daher z.B. die Einzeladern und/oder die Kabel mit mehreren darin gebündelten Einzeladern entsprechend beschriftet.

Dies macht den Anschluss schon deutlich einfacher und fehleranfälliger, jedoch kann es auch hier noch häufig zu Fehlanschlüssen kommen.

Entsprechend kann eine Kodierung auch auf beiden komplementären, d.h. miteinander zu verbindenden Komponenten aufgebracht sein, z.B. auf Stecker und Gegenbuchse, um eine Zuordnungskodierung zu ermöglichen.

Beispielsweise beschreibt DE 20 2008 004 800 U1 ein System, bestehend aus zumindest einem Schaltgerät und zumindest einem elektrisch zu schaltenden Verbraucher, sowie zumindest zwei Verbindungskabeln zur direkten oder indirekten Verbindung von Schaltgerät und Verbraucher, wobei das System zumindest eine Verdrahtungseinheit zum Zusammenschließen der Verbindungskabel umfasst, und wobei Steckverbindungselemente der Verbindungskabel und zumindest zwei Steckverbindungselemente zumindest einer Verdrahtungseinheit, an der die Kabel anschließbar sind, optisch codiert sind.

Der Erfindung liegt demgegenüber als eine Aufgabe zugrunde, ein gegenüber dem Stand der Technik neues Kodierungssystem zu erschaffen, welches eine verbesserte Zuordnung von Leitungsadern zur Übertragung von E/A-Signalen zwischen einem E/A-Modul eines Automatisierungsgerätes zur Ankopplung eines externes Geräts gewährleistet und mit welchem somit schnell und fehlerfrei ein E/A-Modul eines Automatisierungsgerätes und ein externes Gerät miteinander verbunden werden können.

Die Erfindung löst die Aufgabe mit den Merkmalen der unabhängigen Patentansprüche. Bevorzugte Ausführungsformen der Erfindung sind in den abhängigen Patentansprüchen angegeben.

Demgemäß schlägt die Erfindung ein Kodierungssystem nach Anspruch 1.

Die Erfindung bietet als einen wesentlichen Vorteil, dass basierend auf der Bündelung von Adern in Kabeln und einer damit vorgegebenen Clusterung sowie basierend auf der Farbkodierung die Zuordnung von Signal führenden Adern bei der Ankopplung eines externen Gerätes an eine Steuerung eines Automatisierungssystems zumindest teilweise bereits vorgegeben ist, und somit nochmals wesentlich vereinfacht ist, so dass das Risiko von Verschaltungsfehlern und hierdurch begründetem Fehlverhalten des Automatisierungssystems nochmals reduziert und die Montage gleichzeitig erheblich schneller ist, im Vergleich zu Systemen gemäß dem beschriebenen Stand der Technik. Die Farbkodierung beinhaltet hierbei bevorzugt eine Bit-basierte und/oder Byte-basierte Kodierung.

Gemäß einer Ausführungsform weist die farbliche Kodierung eine Farbabstufung auf. Die farbliche Kodierung basiert insbesondere auf unterschiedlichen Farbtönen, Farbsättigungen und/oder Helligkeiten, beispielsweise von hellgrau nach dunkelgrau.

Gemäß einer zu dieser Ausführungsform ergänzenden Ausführungsform ist zusätzlich zur Farbkodierung eine schriftliche Kodierung vorgesehen, insbesondere eine Bit-basierte und/oder Byte-basierte Kodierung.

Gemäß einer bevorzugten Weiterbildung der Erfindung umfasst die Anordnung von Einzeladern zumindest 8 Einzeladern. Dies bietet z.B. den Vorteil mittels der über die zumindest 8 Einzeladern geführten Signale ein Byte darzustellen.

Gemäß einer weiteren bevorzugten Weiterbildung der Erfindung umfasst die Anordnung von Einzeladern zumindest 16 Einzeladern, wobei jeweils wenigstens 8 Einzeladern, ausgehend von dem gemeinsamen Adapter, in jeweils einem Kabel gebündelt sind. Dies bietet z.B. den Vorteil, mittels über ein gemeinsames Kabel geführter Signale ein Byte darzustellen.

Nachfolgend wird die Erfindung beispielhaft anhand bevorzugter Ausführungsformen mit Bezugnahme auf die Zeichnungen näher erläutert. Es zeigen:

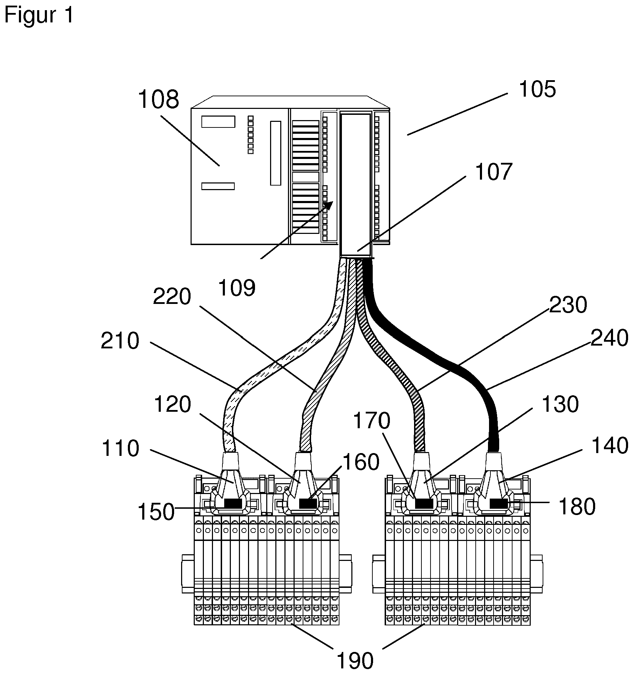

Fig. 1 skizzenhaft eine Ausführungsform eines Kodierungssystems nach der Erfindung mit z.B. 4 farblich abgestuft kodierten Kabeln mit einem gemeinsamen vorverdrahteten Frontadapter einerseits und Steckverbinderanschlüssen andererseits, zur Übertragung von E/A-Signalen zwischen einem E/A-Modul eines Automatisierungsgerätes zur Ankopplung eines externes Geräts und diesem externen Gerät,

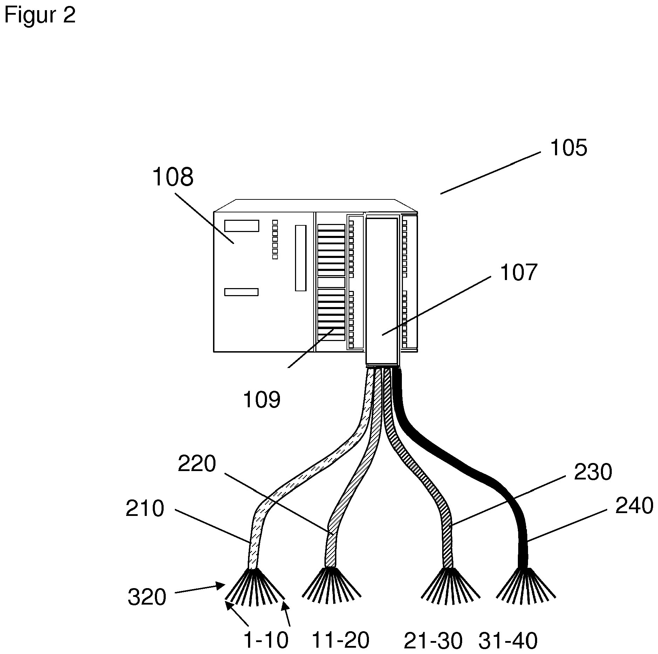

Fig. 2 skizzenhaft eine weitere Ausführungsform eines Kodierungssystems nach der Erfindung mit z.B. 4 farblich abgestuft kodierten Kabeln mit einem gemeinsamen vorverdrahteten Frontadapter einerseits und Einzeladern andererseits, zur Übertragung von E/A-Signalen zwischen einem E/A-Modul eines Automatisierungsgerätes zur Ankopplung eines externes Geräts und diesem externen Gerät, und

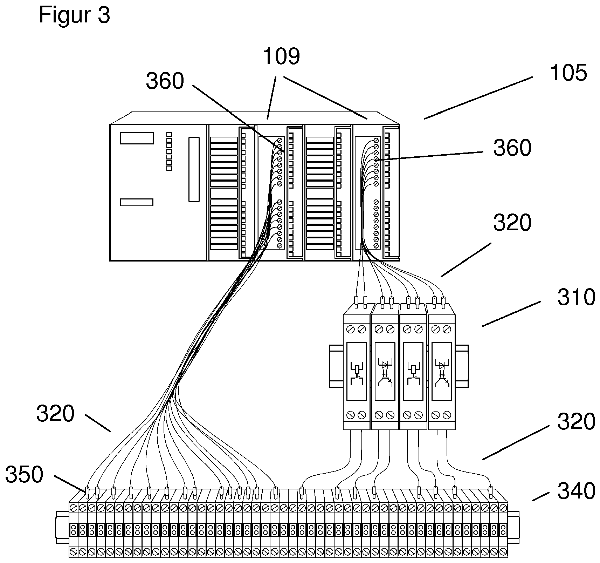

Fig. 3 skizzenhaft einen konventionellen Aufbau nach dem Stand der Technik zur Übertragung von E/A-Signalen zwischen einem E/A-Modul eines Automatisierungsgerätes zur Ankopplung eines externes Geräts und diesem externen Gerät mit Einzeladern.

Für die nachfolgende Beschreibung sei darauf hingewiesen, dass Elemente, die in den Figuren mit denselben Bezugszeichen gekennzeichnet sind, grundsätzlich einander entsprechen.

Bekanntermaßen sind im Rahmen einer Verkabelung von Automatisierungssystemen die Leitungsadern, auch als Einzeladern bezeichnet, zur Übertragung von E/A-Signalen zwischen einem E/A-Modul eines Automatisierungsgerätes zur Ankopplung eines externes Geräts an eine Steuerung und diesem externen Gerät z.B. über einen an das E/A-Modul zu steckenden Stecker zu bündeln und die Leitungsadern von dem an das E/A-Modul gesteckten Stecker entweder in einem einzigen Kabel oder als Einzeladernbündel zu dem externen Gerät zu führen. Das E/A-Modul kann hierbei auch selbst Signalsteuerungs- und/oder Signalverarbeitungsfunktionen übernehmen. Diese Signalsteuerungs- und/oder Signalverarbeitungsfunktionen können hierzu z.B. auch auf einer vom E/A-Modul aufgenommenen, steckbaren E/A-Karte beinhaltet sein, auf welcher diese Funktionen in Hardware, z.B. fest verdrahtet und/oder in Software, z.B. mittels einer Speicher programmierten Steuerung "SPS" hinterlegt sind. Die E/A-Signale können hierbei je nach spezieller Ausführung Analogsignale und/oder Digitalsignale umfassen.

Externe Geräte können hierbei insbesondere Module mit streckbaren Relais und andere Module, aber auch Feldgeräte als solche, wie Aktoren und Sensoren, sein.

Der Anschluss an die externen Geräte erfolgt dann entweder über Klemmen z.B. mit Federkraft- oder Schraubklemmenanschluss oder mit Messertrennklemmen, oder über Steckersysteme wie z.B. das als D-SUB bezeichnete Steckersystem für Datenverbindungen und andere herstellspezifische Steckersysteme.

Die Figur 1 zeigt basierend auf dem vorbeschriebenen Automatisierungsgerät skizzenhaft eine Ausführungsform eines Kodierungssystems nach der Erfindung, welches zumindest eine Anordnung von wenigstens zwei Einzeladern besitzt, wobei jeweils ein Ende einer jeden Einzelader dieser Anordnung an einen gemeinsamen Adapter 107 angeschlossen ist. Der Adapter 107 wiederum ist zur Ankopplung eines externen Gerätes 190 an eine Steuerung mit einem E/A-Modul 109 des Automatisierungsgerätes 105 zu verbinden.

An die externen Geräte 190 können dann wiederum Aktoren, wie z.B. Motoren, Signallampen, etc., und/oder Sensoren, wie z.B. Füllstandssensoren, Endschalter, etc., angekoppelt werden. Alternativ kann ein externes Gerät 190 jedoch z.B. auch ein Aktor oder Sensor als solches sein.

Über den gemeinsamen Adapter 107 ist die Anordnung der Einzeladern somit festgelegt und die Anordnung von Einzeladern ist ausgehend von dem gemeinsamen Adapter 107 in zumindest zwei Kabeln 210, 220, 230, 240 gebündelt, wobei die Kabel farblich kodiert sind.

Das Automatisierungsgerät 105 kann als weitere wesentliche Komponenten ferner eine Stromversorgung und eine CPU (Central Processing Unit) 108 beinhalten.

Gemäß Figur. 1 ist der Adapter 107 auf das E/A Modul 109 gesteckt und verbindet bereits die externen Geräte 190 mit diesem E/A Modul 109 und das Automatisierungsgerät 105 ist hierbei bevorzugt als eine Steuerungseinheit (CPU 108 plus z.B. E/A-Karten) ausgebildet, die somit selbst eine Steuerung eines Automatisierungssystems bereitstellt und autark betrieben werden oder in einem Verbund in einer größeren Anlage in ein übergeordnetes Automatisierungssystem, z.B. ein Leitsystem, eingebunden sein kann.

Das von dem Automatisierungsgerät 105 gemäß Figur 1 beherbergte E/A-Modul 109, welches alternativ auch als ein separates Modul an das Automatisierungsgerät 105 angeschaltet sein kann, z.B. über eine weitere Kabel- oder auch Busverbindung, kann ferner je nach spezieller Ausführung mit analogen und/oder digitalen Ein- und/oder Ausgängen aufgebaut sein.

Der Einfachheit halber basiert die nachfolgende Beschreibung auf einem Aufbau mit digitalen Ein-/Ausgängen.

Wie bei Fig. 1 angedeutet, handelt es sich bei der Farbkodierung des Kabels gemäß dieser Ausführung um eine auf einer Farbabstufung basierende Kodierung. Eine solche kann z.B. auf unterschiedlichen Farbtönen, Farbsättigungen und/oder Helligkeiten basieren.

Da über den gemeinsamen Adapter 107 die Anordnung der Einzeladern festgelegt ist, kann z.B. bestimmten Einzeladern innerhalb der Anordnung ein bestimmtes Bit zugeordnet werden. Umfasst die Anordnung von Einzeladern z.B. zumindest 8 Einzeladern, kann zweckmäßig jeder Einzelader innerhalb der Anordnung nicht nur ein Bit zugeordnet werden sondern mittels der über die zumindest 8 Einzeladern geführten Signale ist folglich ein Byte darstellbar.

Bündelt z.B. jedes Kabel 210, 220, 230, 240 wiederum 8 bis 10 Einzeladern, so kann ferner zweckmäßig mittels der über ein gemeinsames Kabel geführten Signale ein solches Byte dargestellt werden. Bei z.B. 10 Einzeladern pro Kabel können somit noch zusätzliche Signale übertragen werden, einschließlich Strom zuführender und/oder abführender Signale.

Mit einer auf einer Farbabstufung basierenden Kodierung kann das Kabel 210, z.B. für das Byte 0, mit einer ersten Helligkeit eines Farbtons versehen sein und das Kabel 220, z.B. für das Byte 1, mit einer zweiten, insbesondere dunkleren Helligkeit eines identischen oder auch anderen Farbtons. Für das, z.B. das nächste Byte 2 repräsentierende Kabel 230 nimmt die Helligkeit z.B. weiter ab. Die Kabel 210 bis 240 können somit z.B. mit jeweils dunkler werdenden Farbanteilen markiert sein. Ein Anwender braucht dann nur noch mit dem hellsten Kabel zu beginnen und dann das nächst dunklere Kabel anschließen. Als letztes - hier Byte 3 - schließt er das dunkelste Kabel, gemäß Fig. 1 das Kabel 240, an das externe Gerät an. Die Farbkodierung beinhaltet in diesem Fall folglich eine Byte-basierte Kodierung. Infolge dieser Farbkodierung ist folglich auch die Zuordnung von Signal führenden Adern zumindest teilweise bereits vorgegeben. So werden Vertauschungen beim Anschluss wirksam verhindert. Selbstverständlich kann die Zu- bzw. Abnahme der Helligkeit oder andersartige Farbabstufung auch in umgekehrter Reihenfolge erfolgen.

Wie ferner der Figur 1 zu entnehmen ist, können an den Kabeln 210, 220, 230, 240 an deren vom gemeinsamen Adapter 107 entfernten Enden jeweils eine Verbindungsvorrichtung 110, 120, 130, 140 angeordnet sein, an welcher das jeweils andere Ende einer Einzelader angeschlossen ist. Diese bei Figur 1 als Stecker ausgebildeten Verbindungsvorrichtungen dienen entsprechend zur Verbindung mit einem externen Gerät 190 und können überdies alternativ oder ergänzend zur vorbeschriebenen farblichen Kodierung der Kabel 210, 220, 230 und 240 gleichermaßen farblich kodiert sein, welches bei Figur 1 jedoch aus Gründen der Übersichtlichkeit nicht weiter dargestellt ist.

Auch durch eine solche farbliche Kodierung, insbesondere Farbabstufung, ist das Risiko von Verschaltungsfehlern und hierdurch begründetem Fehlverhalten des Automatisierungssystems nochmals reduziert.

Optional kann ergänzend zur farblichen Kodierung noch eine schriftliche Kodierung vorgesehen sein, z.B. eine Bit-basierte und/oder Byte-basierte Kodierung.

Gemäß Ausführungsbeispiel nach Figur 1 ist eine solche schriftliche Kodierung zweckmäßig auf den als Stecker ausgebildeten Verbindungsvorrichtungen 110, 120, 130, 140 aufgebracht. Die Verbindungsvorrichtung 110 weist eine schriftliche Kodierung 150, z.B. "Byte 0", auf, die Verbindungsvorrichtung 120 eine schriftliche Kodierung 160, z.B. "Byte 1", die Verbindungsvorrichtung 130 eine schriftliche Kodierung 170, z.B. "Byte 2", und die Verbindungsvorrichtung 140 eine schriftliche Kodierung 180, z.B. "Byte 3".

Die Figur 2 zeigt eine gegenüber der Ausführungsform nach Fig. 1 abgewandelte Ausführungsform auf.

In Abwandlung zur Figur 1 sind bei der Ausführungsform nach Figur 2 an den Kabeln 210, 220, 230, 240 an deren vom gemeinsamen Adapter 107 entfernten Enden keine als Stecker ausgebildeten Verbindungsvorrichtungen angeordnet. Vielmehr schauen aus diesen Kabelenden die Enden der Einzeladern 320 hervor, welche dann einzeln, z.B. mittels bei Figur 3 dargestellten Schraubanschlussklemmen 350, an ein externes Gerät anzuschließen sind.

Auch hierbei bietet die Bündelung von jeweils mehreren Einzeladern in verschiedenen Kabeln, beispielsweise von 40 Einzeladern 320 in 4 Kabeln 210, 220, 230, 240 zusammen mit der Farbkodierung der Kabel, insbesondere mittels einer vorbeschriebenen Farbabstufung, eine deutlich verbesserte Zuordnung.

Ergeben sich nach dem Stand der Technik bei 32 ungebündelten Leitungsadern an deren vom gemeinsamen Adapter 107 entfernten Enden grundsätzlich 528 Anschlussmöglichkeiten und bei 40 ungebündelten Leitungsadern grundsätzlich 820 Anschlussmöglichkeiten, um die gewünschten bzw. korrekten Einzeladern zu finden, ergeben sich bei 40, an einen gemeinsamen Adapter 107 angeschlossenen Einzeladern, welche von diesem Adapter ausgehend in 4 Kabeln zu je 10 Einzeladern gebündelt sind, lediglich max. 220 Anschlussmöglichkeiten.

Hierbei berechnen sich die max. Anschlussmöglichkeiten pro Kabel (10 Adern) wie folgt:

- eine Ader aus 10 möglichen Adern identifizieren,
- eine Ader aus 9 möglichen Adern identifizieren,
- eine Ader aus 8 möglichen Adern identifizieren, und so weiter.

Die max. Möglichkeiten pro Kabel (10 Adern) ergeben sich aus der Gaußschen Summenformel:

$$\sum_{k=1}^{n} k = \frac{n(n+1)}{2} \,,$$

wobei n die Anzahl der Einzeladern in einem Kabel und k die Anschlussmöglichkeiten für jede Einzelader innerhalb des Kabels ist. Bei 10 Einzeladern ergeben sich folglich pro Kabel

$$\sum_{k=1}^{n} k = \frac{n(n+1)}{2} = \frac{10(10+1)}{2} = 55$$

Da im hier angeführten Beispiel 4 Kabel mit je 10 gebündelten Einzeladern gewählt wurden, ist die Summe für 4 Kabel somit gleich 4*55=220 Möglichkeiten. Dies ist gegenüber der Einzeladernverdrahtung mit max. 820 Möglichkeiten eine deutliche Reduzierung des Risikos eines Verdrahtungsfehlers und eine große Zeitersparnis.

Basierend auf der vorgehenden Beschreibung liegt somit auch ein E/A-Modul 109 eines Automatisierungsgerätes 105 im Rahmen der Erfindung, welches zur Ankopplung eines externen Gerätes an eine Steuerung eines Automatisierungssystems wenigstens einen Adapter 107 besitzt, an welchen eine Anordnung von mehreren Einzeladern mit jeweils einem Ende einer jeden Einzelader angeschlossen ist, so dass über den gemeinsamen Adapter die Anordnung der Einzeladern festgelegt ist, und wobei die Anordnung von Einzeladern ausgehend von dem gemeinsamen Adapter 107 in zumindest zwei Kabeln 210, 220, 230, 240 gemäß obiger Beschreibung gebündelt und die in den zumindest zwei Kabeln gebündelte Anordnung farblich kodiert ist.

Die Figur 3 zeigt beispielhaft noch die Verdrahtung von ungebündelten Einzeladern 320 ohne jegliche Farbkodierung sowohl auf Seiten von E/A-Modulen 109 eines Automatisierungsgerätes 105 als auch auf Seiten externer Geräte 310 und 340 nach dem Stand der Technik. Die an die externen Geräte 310 und 340 angeschlossenen Enden der Einzeladern 320 sind beispielhaft mittels Schraubanschlussklemmen 350 angeschlossen und die auf Seiten der E/A-Module 109 angeschlossenen Enden der Einzeladern z.B. mittels Schraubanschlussklemmen 360.

Sind z.B., wie bei Fig. 3 dargestellt, 14 Einzeladern direkt zwischen einem E/A-Modul 109 und dem extern Gerät 340 anzuschließen, ergeben sich nach Anschluss der Einzeladern an dem E/A-Modul 109 105 Anschlussmöglichkeiten, um auf Seiten des externen Gerätes 340 die dortigen Leitungsadern-Enden in der durch das E/A-Modul 109 bestimmten Anordnung zu identifizieren und an dem extern Gerät 340 gemäß einer vorbestimmten Adernzuordnung entsprechend anzuschließen. Bei einer Bündelung dieser 14 Einzeladern gemäß der Erfindung innerhalb z.B. zwei Kabeln mit je 7 Adern, wobei die Kabel darüber hinaus noch eine Farbkodierung nach der Erfindung aufweisen, ist bereits über diese Farbkodierung auch die Zuordnung von Signal führenden Adern innerhalb eines Kabels zumindest teilweise bereits vorgegeben, so dass sich insgesamt lediglich noch 56 Anschlussmöglichkeiten ergeben.

Bezugszeichenliste

105 Automatisierungsgerät,
107 Adapter,
108 CPU
109 E/A-Modul,
110, 120, 130, 140 Verbindungsvorrichtungen,
150, 160, 170, 180 schriftliche Kodierungen,
190 externe Geräte bzw. Peripheriemodule,
210, 220, 230, 240 Kabel,
310, 340 externe Geräte bzw. Peripheriemodule,
320 Einzeladern,
350 Schraubanschlussklemmen,
360 Schraubanschlussklemmen.

**Patentansprüche**

1. Kodierungssystem zur Zuordnung von Leitungsadern zur Übertragung von E/A-Signalen zwischen einem E/A-Modul (109) eines Automatisierungsgerätes und einem externen Gerät, wobei das Kodierungssystem eine Anordnung von mehreren Einzeladern besitzt, und wobei jeweils ein Ende einer jeden Einzelader dieser Anordnung an einen gemeinsamen Adapter (107) angeschlossen ist, welcher mit dem E/A-Modul (109) des Automatisierungsgerätes zur Ankopplung eines externen Gerätes an eine Steuerung eines Automatisierungssystems zu verbinden ist, wobei über den gemeinsamen, mit dem E/A-Modul zu verbindenden Adapter die Anordnung der Einzeladern festgelegt ist, und wobei die Anordnung von Einzeladern ausgehend von dem gemeinsamen Adapter (107) in zumindest zwei Kabeln (210, 220, 230, 240) gebündelt ist, und die Kabel farblich kodiert sind, und wobei aus den vom gemeinsamen Adapter (107) entfernten Kabelenden der zumindest zwei Kabel (210, 220, 230, 240) jeweils die Enden der Einzeladern hervorschauen, welche einzeln an das externe Gerät anzuschließen sind.

2. Kodierungssystem zur Zuordnung von Leitungsadern zur Übertragung von E/A-Signalen zwischen einem E/A-Modul (109) eines Automatisierungsgerätes und einem externen Gerät, wobei das Kodierungssystem eine Anordnung von mehreren Einzeladern besitzt, wobei jeweils ein Ende einer jeden Einzelader dieser Anordnung an einen gemeinsamen Adapter (107) angeschlossen ist, welcher mit einem E/A-Modul (109) eines Automatisierungsgerätes zur Ankopplung eines externen Gerätes an eine Steuerung eines Automatisierungssystems zu verbinden ist, wobei über den gemeinsamen, mit dem E/A-Modul zu verbindenden Adapter die Anordnung der Einzeladern festgelegt ist, und wobei die Anordnung von Einzeladern ausgehend von dem gemeinsamen Adapter (107) in zumindest zwei Kabeln (210, 220, 230, 240) gebündelt ist, an deren vom gemeinsamen Adapter (107) entfernten Ende jeweils eine Verbindungsvorrichtung (110, 120, 130, 140) angeordnet ist, an welcher das jeweils andere Ende einer Einzelader angeschlossen ist, und wobei diese Verbindungsvorrichtungen farblich kodiert sind.

3. Kodierungssystem nach Anspruch 1 oder 2, wobei die farbliche Kodierung eine Farbabstufung aufweist.

4. Kodierungssystem nach einem der Ansprüche 1 bis 3, wobei die farbliche Kodierung auf unterschiedlichen Farbtönen, Farbsättigungen und/oder Helligkeiten basiert.

5. Kodierungssystem nach einem der vorstehenden Ansprüche, wobei zusätzlich zur farblichen Kodierung eine schriftliche Kodierung vorgesehen ist.

6. Kodierungssystem nach Anspruch 5, wobei die schriftliche Kodierung eine Bitkodierung aufweist.

7. Kodierungssystem nach einem der vorstehenden Ansprüche, wobei die Anordnung von Einzeladern zumindest 8 Einzeladern umfasst.

8. Kodierungssystem nach einem der vorstehenden Ansprüche, wobei die Anordnung von Einzeladern zumindest 16 Einzeladern umfasst, wobei insbesondere jeweils wenigstens 8 Einzeladern ausgehend von dem gemeinsamen Adapter (107) in jeweils einem Kabel gebündelt sind.

9. E/A-Modul (109) eines Automatisierungsgerätes, welches zur Ankopplung eines externen Gerätes an eine Steuerung eines Automatisierungssystems ein Kodierungssystem nach einem der vorstehenden Ansprüche besitzt.

10. E/A-Modul (109) eines Automatisierungsgerätes, nach Anspruch 9, welches zur Ankopplung eines externen Gerätes an eine Steuerung eines Automatisierungssystems wenigstens einen Adapter (107) besitzt, an welchen eine Anordnung von mehreren Einzeladern mit jeweils einem Ende einer jeden Einzelader angeschlossen ist, wobei über den gemeinsamen Adapter die Anordnung der Einzeladern festgelegt ist, und wobei die Anordnung von Einzeladern ausgehend von dem gemeinsamen Adapter (107) in zumindest zwei Kabeln (210, 220, 230, 240) gebündelt und die in den zumindest zwei Kabeln gebündelte Anordnung farblich kodiert ist.

**Claims**

1. Coding system for allocation of conductor wires for transmission of I/O signals between an I/O module of an automation device and an external device, wherein the coding system comprises an assembly of a plurality of individual wires, and wherein one end of each individual wire of this assembly is connected to a common adapter (107) which is to be connected to the I/O module (109) of the automation device for coupling an external device to a control unit of an automation system, wherein the order of the individual wires is defined by the common adapter to be connected to the I/O module, and wherein the assembly of individual wires is bundled into at least two cables (210, 220, 230, 240) emanating from the common adapter (107), and wherein the cables are color-coded, and wherein from the distal cable ends of the at least two cables (210, 220, 230, 240) remote from common adapter (107), the respective ends of the individual wires appear, which have to be individually connected to the external device.

2. Coding system for allocation of conductor wires for transmission of I/O signals between an I/O module of an automation device and an external device, wherein the coding system comprises an assembly of a plurality of individual wires, wherein one end of each individual wire of this assembly is connected to a common adapter (107) which is to be connected to an I/O module (109) of an automation device for coupling an external device to a control unit of an automation system, wherein the order of the individual wires is defined by the common adapter to be connected to the I/O module, and wherein the assembly of individual wires is bundled into at least two cables (210, 220, 230, 240) emanating from the common adapter (107), and wherein a respective connection device (110, 120, 130, 140) is arranged at the distal end of each cable remote from the common adapter (107), to which the respective other end of each individual wire is connected, and wherein said connection devices are color-coded.

3. Coding system according to claim 1 or 2, wherein the color code comprises a color gradation.

4. Coding system according to any of claims 1 to 3, wherein the color code is based on different hues, color saturations, and/or lightnesses.

5. Coding system according to any of the preceding claims, wherein in addition to the color code, a written code is provided.

**6.** Coding system according to claim 5, wherein the written code comprises a bit code.

**7.** Coding system according to any of the preceding claims, wherein the assembly of individual wires comprises at least 8 individual wires.

**8.** Coding system according to any of the preceding claims, wherein the assembly of individual wires comprises at least 16 individual wires, wherein in particular at least 8 individual wires are bundled into each respective cable emanating from the common adapter (107).

**9.** I/O module (109) of an automation device, comprising a coding system according to any of the preceding claims, for coupling an external device to a control unit of an automation system.

**10.** I/O module (109) of an automation device, according to claim 9, comprising at least one adapter (107) for coupling an external device to a control unit of an automation system, wherein an assembly of a plurality of individual wires is connected to said adapter with a respective end of each individual wire, wherein the order of the individual wires is defined by the common adapter, and wherein the assembly of individual wires is bundled into at least two cables (210, 220, 230, 240) emanating from the common adapter (107), and wherein the assembly bundled in the at least two cables is color-coded.

**Revendications**

**1.** Système de codage permettant l'affectation de brins conducteurs pour la transmission de signaux E/S entre un module E/S (109) d'un appareil d'automatisation et un appareil externe, dans lequel le système de codage possède un agencement de plusieurs brins individuels, et dans lequel respectivement une extrémité de chaque brin individuel de cet agencement est raccordée à un adaptateur (107) commun, lequel est à relier au module E/S (109) de l'appareil d'automatisation pour le couplage d'un appareil externe à une commande d'un système d'automatisation, dans lequel l'agencement des brins individuels est fixé par l'intermédiaire de l'adaptateur commun à relier au module E/S, et dans lequel l'agencement de brins individuels est assemblé en faisceaux à partir de l'adaptateur (107) commun en au moins deux câbles (210, 220, 230, 240), et les câbles présentent un code couleur, et dans lequel respectivement les extrémités des brins individuels, lesquelles sont à raccorder individuellement à l'appareil externe, dépassent des extrémités de câble des au moins deux câbles (210, 220, 230, 240), lesquelles extrémités sont éloignées de l'adaptateur (107) commun.

**2.** Système de codage permettant l'affectation de brins conducteurs pour la transmission de signaux E/S entre un module E/S (109) d'un appareil d'automatisation et un appareil externe, dans lequel le système de codage possède un agencement de plusieurs brins individuels, dans lequel respectivement une extrémité de chaque brin individuel de cet agencement est raccordée à un adaptateur (107) commun, lequel est à relier à un module E/S (109) d'un appareil d'automatisation pour le couplage d'un appareil externe à une commande d'un système d'automatisation, dans lequel l'agencement des brins individuels est fixé par l'intermédiaire de l'adaptateur commun à relier au module E/S, et dans lequel l'agencement de brins individuels est assemblé en faisceaux à partir de l'adaptateur (107) commun en au moins deux câbles (210, 220, 230, 240), à l'extrémité desquels, laquelle extrémité est éloignée de l'adaptateur (107) commun, est agencé respectivement un dispositif de liaison (110, 120, 130, 140), auquel l'autre extrémité d'un brin individuel est raccordé, et dans lequel ces dispositifs de liaison présentent un code couleur.

**3.** Système de codage selon la revendication 1 ou 2, dans lequel le code couleur présente un dégradé de couleurs.

**4.** Système de codage selon l'une quelconque des revendications 1 à 3, dans lequel le code couleur se base sur différentes teintes, saturations de couleur et/ou luminosités.

**5.** Système de codage selon l'une quelconque des revendications précédentes, dans lequel un codage écrit est prévu en plus du code couleur.

**6.** Système de codage selon la revendication 5, dans lequel le codage écrit présente un codage binaire.

**7.** Système de codage selon l'une quelconque des revendications précédentes, dans lequel l'agencement de brins individuels comporte au moins huit brins individuels.

**8.** Système de codage selon l'une quelconque des revendications précédentes, dans lequel l'agencement de brins individuels comporte au moins seize brins individuels, dans lequel en particulier respectivement au moins huit brins individuels sont assemblés en faisceaux à partir de l'adaptateur (107) commun de manière à obtenir respectivement un câble.

**9.** Module E/S (109) d'un appareil d'automatisation, lequel, pour le couplage d'un appareil externe à une commande d'un système d'automatisation, possède un système de codage selon l'une quelconque des revendications précédentes.

**10.** Module E/S (109) d'un appareil d'automatisation selon la revendication 9, lequel, pour le couplage d'un appareil externe à une commande d'un système d'automatisation, possède au moins un adaptateur (107), auquel un agencement de plusieurs brins individuels est raccordé par respectivement une extrémité de chaque brin individuel, dans lequel l'agencement des brins individuels est fixé par l'intermédiaire de l'adaptateur commun, et dans lequel l'agencement des brins individuels est assemblé en faisceaux à partir de l'adaptateur (107) commun en au moins deux câbles (210, 220, 230, 240) et l'agencement assemblé en faisceaux en au moins deux câbles présente un code couleur.

Figur 1

Figur 2

Figur 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4016445 A1
- DE 4395807 T1
- DE 202008004800 U1

**In der Beschreibung aufgeführte Nicht-Patentliteratur**

- *Optimierung der Feldverdrahtung durch Einsatz einer modularen IP 67-Feldbuslösung,* 09. November 2009, 1-64